# EUROPÄISCHE PATENTSCHRIFT

(11) **EP 2 666 189 B1**
(45) Veröffentlichungstag und Bekanntmachung des Hinweises auf die Patenterteilung: **03.04.2019**
(21) Anmeldenummer: 12703254.8
(22) Anmeldetag: 19.01.2012
(51) Int. Cl.: H01L 31/05, H01L 31/054, H01L 31/18, C23C 24/10

(54) **VERFAHREN ZUM HERSTELLEN VON VORVERZINNTEN VERBINDERN FÜR PHOTOVOLTAIK-ZELLEN UND ZUM VERZINNEN EINER METALLFOLIE MIT IN EINER RICHTUNG VERLAUFENDER RILLENSTRUKTUR**
PROCESS FOR PRODUCING PRE-TINNED CONNECTORS FOR PHOTOVOLTAIC CELLS AND FOR TINNING A METAL FOIL HAVING A ONE-DIRECTIONAL GROOVE STRUCTURE
PROCÉDÉ POUR FABRIQUER DES CONNECTEURS PRÉ-ÉTAMÉS POUR CELLULES PHOTOVOLTAÏQUES ET UNE FEUILLE MÉTALLIQUE POURVUE D'UNE STRUCTURE RAINURÉE S'ÉTENDANT DANS UNE DIRECTION

(30) Priorität: 20.01.2011 DE 102011009006
(43) Veröffentlichungstag der Anmeldung: 27.11.2013
(73) Patentinhaber: Schlenk Metallfolien Gmbh & Co. Kg, 91154 Roth-Bernlohe (DE)
(72) Erfinder: BOOZ, Thomas, 91154 Roth (DE); DISTELRATH, Fabian, 91154 Roth (DE)
(74) Vertreter: Gritschneder, Sebastian
(86) Internationale Anmeldenummer: PCT/EP2012/050816
(87) Internationale Veröffentlichungsnummer: WO 2012/098205

(56) Entgegenhaltungen:
- EP-A1- 1 626 443
- WO-A1-2006/128203
- DE-A1- 4 038 765
- BOOZ T: "Light-Capturing Interconnect Wire for 2% Module Power Gain", THE COMPILED STATE-OF-THE-ART OF PV SOLAR TECHNOLOGY AND DEPLOYMENT : 24TH EUROPEAN PHOTOVOLTAIC SOLAR ENERGY CONFERENCE AND EXHIBITION ; CONFERENCE 21 - 25 SEPTEMBER 2009, EXHIBITION 21 - 24 SEPTEMBER 2009, HAMBURG ; PROCEEDINGS ; EU PVSEC, WIP-RENE, 25. September 2009 (2009-09-25), Seiten 3222-3225, XP040530528, ISBN: 978-3-936338-25-6

## Beschreibung

Die Erfindung betrifft ein Verfahren zum Herstellen von vorverzinnten Verbindern für PV-Zellen (Photovoltaik-Zellen), wobei die Verbinder eine in Längsrichtung verlaufende Rillenstruktur aufweisen. Ferner betrifft die Erfindung eine Metallfolie mit einer in Längsrichtung verlaufenden Rillenstruktur auf zumindest einer Seite.

Ein Verbinder für PV-Zellen ist ein Streifen aus elektrisch leitendem Material, der einen flachen Querschnitt mit einer ersten und einer zweiten sich über seine gesamte Länge erstreckenden Breitseite und mit zwei Schmalseiten aufweist, die jeweils die gegenüberliegenden Ränder der Breitseiten verbinden. Zumindest die erste Breitseite weist eine in Längsrichtung des Streifens verlaufende Rillenstruktur auf.

Verbinder für PV-Zellen sind in ihrer Lieferform üblicherweise als Bänder großer Länge auf Rollen gewickelt und werden dann einzeln von diesen Bändern abgeschnitten. Die Definition der ersten und zweiten Breitseite oder der Ober- und Unterseite ergibt sich aus der Wicklung in der fertigen Lieferform und ist insofern beliebig.

In der Photovoltaik werden die Verbinder eingesetzt, um die einzelnen PV-Zellen zu einem PV-Modul zu verbinden. Eine Anzahl von zum Beispiel fünf PV-Zellen wird dabei mittels der Verbinder in Serie verbunden. Jeder Verbinder stellt den elektrischen Anschluss zwischen zwei aufeinander folgenden Zellen eines PV-Moduls her. In der Regel werden die Verbinder bei PV-Zellen aus kristallinem Silizium eingesetzt. Sie können aber auch bei Dünnschicht-PV-Zellen zum Einsatz kommen. Die Verbinder sollen die elektrischen Pole (positiv und negativ) benachbarter Zellen, entsprechend der gewünschten Verschaltung, innerhalb des PV-Moduls sicher miteinander verbinden. Da die PV-Zellen in Serie verschaltet werden (positiv zu negativ) und die Orientierung der Pole jeder Zelle gleich ist, wird der Verbinder mit der Oberseite (sog. "sunny side) einer Zelle und dann mit der Unterseite (sog. "shady side") der nächsten Zelle verlötet.

Konventionelle Verbinder von PV-Zellen sind Streifen aus elektrisch leitendem Material, im Allgemeinen Kupfer, wobei beide Breitseiten glatt sind. Der Streifen ist je nach Herstellungsverfahren allseitig (tauchverzinnter gewalzter Draht) oder zweiseitig (geschnittenes Band) mit einem Weichlot vorverzinnt. Die Lotbeschichtung ist auf der gesamten Länge des Verbinders durchgehend aufgebracht. In der Regel auf beiden Seiten gleichmäßig in der gleichen Dicke. Die Dickenverteilung der Zinnschicht in Querrichtung kann je nach Herstellungsart variieren. Beim tauchverzinnten Draht kommt es zu einer Linsenbildung. Beim geschnittenen Band bleibt die Dicke der Lotauflage über die Breite konstant.

PV-Zellen-Verbinder mit Rillenstruktur sind aus der Veröffentlichung "OPTIMISATION OF CELL INTERCONNECTORS FOR PV MODULE PERFORMANCE ENHANCEMENT", 14th EUROPEAN PHOTOVOLTAIC SOLAR ENERGY CONFERENCE, BARCELONA, SPAIN, 30 Juni bis 4 Juli 1997, bekannt, sowie aus US-2007/0125415 A1und aus JP 2006-013406. Wie in diesen Veröffentlichungen beschrieben, kann bei einem optimalen Winkel α an den Spitzen der Rillenstruktur von 100-140°, vorzugsweise 120°, etwa 80 % des auf die Verbinder fallenden Lichtes durch Totalreflexion innerhalb der PV-Zelle zur Stromerzeugung nutzbar gemacht werden, wodurch der Gesamtwirkungsgrad der PV-Zelle etwa um 2% verbessert wird. Zur Erhöhung der Reflexion kann die Oberfläche der Rillenstruktur versilbert werden. In diesen Druckschriften ist nicht angegeben, wie die Verbinder an den PV-Zellen angelötet werden. Konventionelle Verbinder mit ebenen Breitseiten werden durch Tauchlöten vorverzinnt. Dies führt jedoch bei Verbindern mit Rillenstruktur nicht zu einer ausreichenden Vorverzinnung, die ein sicheres Anlöten der Verbinder in einem automatischen Verfahren ermöglicht. Verbinder mit Rillenstruktur könnten daher nur durch externe Lotzufuhr, z.B. mittels eines Dispenskopfes, an PV-Zellen angelötet werden.

Das Dokument WO 2006/128203 A offenbart Verbindungselemente für Solarzellen die aus einem mit leitfähigem Material wie z.B. Zinn beschichteten elektrischen Leiter bestehen. Der elektrische Leiter weist eine Strukturierung zur Verbesserung des Kraftschlusses der Lötverbindung mit der Solarzelle auf.

Dokument DE 40 38 765 A offenbart ein Verfahren zur Aufbringung einer Lotschicht auf einem elektrischen Anschlussteil, wobei ein Lotplättchen mittels Laser aus einem Folienband ausgeschnitten, auf das Anschlussteil aufgebracht und dort aufgeschmolzen wird.

Aus der Veröffentlichung Sachs et al, "LIGHT CAPTURING INTERCONNECT WIRE FOR 2% MODULE POWER GAIN", 24th European Solar Energy Conference, 21-25 September 2009, Hamburg, Germany, ist ein Verfahren zur Herstellung von PV-Zellen-Verbindern mit Rillen an der Oberseite und einer Zinnschicht auf der Rückseite aus einer Metallfolie bekannt.

Der Erfindung liegt die Aufgabe zu Grunde, ein Verfahren zum Herstellen von vorverzinnten PV-Zellen-Verbindem mit einer Rillenstruktur auf mindestens einer der beiden Breitseiten anzugeben, so dass sich die vorverzinnten Verbinder einfach und zuverlässig mit PV-Zellen verlöten lassen.

Erfindungsgemäß wird diese Aufgabe dadurch gelöst,
- dass eine Metallfolie durch einen Walzenspalt eines Walzenaggregats geführt wird, bei dem zumindest eine Walze eine Oberfläche mit einer Rillenstruktur hat, so dass zumindest in eine Seite der Metallfolie eine Rillenstruktur geprägt wird, die Kämme oder Scheitel und Täler aufweist,
- dass Lötzinn in Form von Lotformteilen (Folienabschnitten) auf die Seite der Metallfolie aufgelegt wird, die eine eingeprägte Rillenstruktur aufweist, wobei das für die Verzinnung erforderliche Lötflussmittel zuvor auf die Lotformteile oder die Metallfolie aufgetragen worden ist,
- dass die Lotformteile auf die Metallfolie aufgeschmolzen werden, und
- dass die die eingeprägte Rillenstruktur aufweisende und verzinnte Metallfolie in parallele Bänder getrennt wird,
wobei die Lotformteile eine solche Stärke haben, dass nach dem Aufschmelzen der Lotformteile die Rillenstruktur mindestens aufgefüllt ist.

Die Bänder können zu schmalen oder traversen Rollen aufgewickelt werden. Aus diesen Bändern werden dann die einzelnen Verbinder abgeschnitten.

Vor dem Aufschmelzen können die Lotformteile zunächst mit der Metallfolie verbunden oder fixiert werden. Das Verbinden der Lotformteile mit der Metallfolie kann dadurch erfolgen, dass die vorgeschnittenen Lotformteile mittels eines Sauggreifers auf der Metallfolie platziert werden, dass die vom Sauggreifer noch ortsfest gehaltenen Lotformteile punktuell mit einem ersten Heißprägekopf auf der Metallfolie angeheftet werden, dass die angehefteten Lotformteile dann mit einem zweiten Heißprägekopf vollflächig mit der Metallfolie verpresst werden, wobei die Temperatur wenige Grad Celsius unter der Liquidustemperatur liegt, so dass das Lot weich oder breiig ist, und dass schließlich die angehefteten und vollflächig verpressten Lotformteile aufgeschmolzen werden.

Alternativ können die Lotformteile auch einfach auf die Metallfolie abgelegt werden, die zuvor mit Lötflussmittel versehen wurde, so dass sie noch feucht ist. Damit die Lotformteile nicht verrutschen, werden sie mittels eines Niederhalters leicht auf die Metallfolie gedrückt. Das Anheften der Lotformteile mittels des ersten Heißprägekopfes entfällt dann.

Die Lotformteile haben eine solche Stärke, dass die Vorverzinnung die in Längsrichtung verlaufende Rillenstruktur mindestens auffüllt. Um die Verarbeitung der aus der Metallfolie herzustellenden vorverzinnten Verbinder in großen Lauflängen zu ermöglichen, stehen die vorverzinnten Bereiche zweckmäßig nur geringfügig über die Kämme oder Scheitel der unbeschichteten Rillenstruktur hervor. Die Rillenstruktur nimmt das Lotmaterial nahezu vollständig auf, so dass das Lotmaterial nur geringfügig über die Kämme oder Scheitel der Rillenstruktur hinausgeht. Der geringe Überstand ist für eine später erfolgreiche Verlötung der Verbinder zweckmäßig.

Vorzugsweise hat auch die andere Walze des Walzenaggregats eine Rillenstruktur, so dass die Metallfolie auf beiden Seiten eine Rillenstruktur erhält. Die Rillenstruktur kann auf beiden Seiten gleich oder unterschiedlich ausgeführt werden.

Wenn die Metallfolie nur auf einer Seite, der Oberseite, die Rillenstruktur aufweist, so kann die andere, glatte Seite, die Unterseite, z.B. durch Schwalllöten vollständig verzinnt werden. Die Oberseite braucht dann nur in den Bereichen verzinnt zu werden, die später zu den Bereichen werden, mit denen die herzustellenden PV-Zellen-Verbinder auf die Rückseite der PV-Zellen gelötet werden.

Die Metallfolie hat vorzugsweise einer Stärke von 0,1 bis 0,25 mm und einer Breite von 30 bis 90 mm. Die Walzen haben vorzugsweise eine Oberfläche mit einer Rillenstruktur mit einem Scheitelabstand von 150-250 µm und einer Tiefe von etwa 30 bis 50 µm, so dass sich der optimale Winkel α an den Spitzen der Rillenstruktur von 100-140°, vorzugsweise 120°, ergibt. Die Rillenstruktur der Metallfolie weist dann jeweils in Längs- oder Vorschubrichtung des Walzenaggregats verlaufende Kämme oder Scheitel und Täler auf.

Bei Scheitelabständen der Rillenstruktur von deutlich weniger als 150 µm reduziert sich die Ausbeute der PV-Zellen durch Verluste an den Spitzen (Kämme oder Scheitel) der Rillen. Je größer der Abstand gewählt wird, desto tiefer wird das Profil der Rillenstruktur, was zu Fertigungsproblemen führen kann. Außerdem wird dadurch der Streifen insgesamt unnötig dick. Besonders bevorzugt ist ein Scheitelabstand von etwa 150 µm.

Die eingesetzte Metallfolie kann entweder blank sein oder ein- oder beidseitig mit Silber, Zinn oder Nickel beschichtet sein. Vorzugsweise ist die Metallfolie zur Verbesserung der Reflexionseigenschaften des daraus hergestellten PV-Zellen-Verbinders mit Silber beschichtet. Die Vorverzinnung wird auf die dünne Silberschicht aufgebracht.

Vorzugsweise werden nur diejenigen Flächenabschnitte der gerillten Metallfolie vorverzinnt, die später die Abschnitte des Verbinders bilden, die mit den PV-Zellen verlötet werden. Dazu wird das Lötzinn in Form von Lotformteilen (Folienabschnitten) auf die Metallfolie aufgelegt. Die Lotformteile sind Streifen, deren Breite der Länge der ersten und zweiten Bereiche des Streifens des Verbinders entspricht, also etwas weniger als die Kantenlänge der PV-Zellen, für die die herzustellenden Streifen bestimmt sind.

Die Länge der Lotflächen der beiden Seiten kann unterschiedlich sein. Die Lotfläche bzw. die Lotflächen können auch in sich unterbrochen sein. Die Bänder der PV-Zellen-Verbinder haben in der Lieferform, d.h. in großen auf Rollen gewickelten Längen, zweckmäßig eine in sich konstante Abfolge der Lotflächen der ersten und zweiten Bereiche auf der jeweiligen Breitseite. Die Längen der unbeschichteten Flächen vor und nach einer Lotfläche können verschieden sein. Vorzugsweise wiederholen sie sich aber im gleichen Rhythmus. Die Lage der beiden Abfolgen auf der ersten und zweiten Breitseite ist im Allgemeinen zueinander fixiert und definiert.

Bei einer Metallfolie, aus der Verbinder für Sechs-Zoll-Zellen hergestellt werden sollen, haben die Lotformteile in Längsrichtung typischerweise eine Länge von 145 mm, d.h. etwas weniger als die Kantenlänge einer Sechs-Zoll-Zelle.

Wenn beide Seiten der Metallfolie vorverzinnt werden, haben vorzugsweise die Lotformteile der einen Seite einen Abstand in Längsrichtung von denen der anderen Seite, der etwa dem Abstand zweier miteinander zu verbindender PV-Zellen entspricht. Die ersten Bereiche und die zweiten Bereiche der später aus der Metallfolie geschnittenen PV-Zellen-Verbinder haben dann in Längsrichtung ebenfalls diesen Abstand. Dieser Abstand beträgt typischerweise 15 mm. Da die Verbinder von einem fortlaufenden Band abgeschnitten werden, muss noch ein Schnittspiel von 0,5 mm berücksichtigt werden. Insgesamt ergibt sich damit eine typische Länge des Verbinders und damit ein Raster der Lotformteile von 305,5 mm.

Bei anderen PV-Zellen sind die ersten und zweiten Bereiche und dementsprechend die Abmessung der Lotformteile in Längs- oder Förderrichtung entsprechen kleiner oder größer.

Die Rillenstruktur der Walzen kann umlaufend oder achsparallel sein, und die Rillenstruktur in der Folie verläuft dementsprechend in Richtung des Transportes oder Vorschubs durch den Walzenspalt oder quer dazu.

Wenn die Rillenstruktur der Walzen umlaufend ist, wird die Folie noch in Längsrichtung in schmale, parallele Bänder geschnitten, wobei die Breite des Bandes gleich der Breite der PV-Verbinder ist. Dieses Band wird im Allgemeinen zu schmalen, einlagigen oder traversen Rollen aufgewickelt. Aus diesen Bändern werden dann die einzelnen Verbinder abgeschnitten.

Wenn die Rillenstruktur der Walzen achsparallel ist, so ist die Breite des Bandes zweckmäßig von vornherein gleich der Länge der herzustellenden PV-Verbinder. Das Band wird zu einer einlagigen Rolle gewickelt, und aus dem Band werden die PV-Verbinder dann abgeschnitten.

Vorzugsweise ist die Rillenstruktur der Walzen umlaufend und verläuft die Rillenstruktur der Folie in Längsrichtung.

Die unbeschichteten Flächen zwischen den Lotflächen können mit einer Isolationsschicht versehen sein. Dazu kann vor oder - vorzugsweise - nach dem Auflegen, Anheften, vollflächigen Heißpressen und Aufschmelzen der Lotformteile eine Isolationsfolie durch Heißsiegel aufgebracht werden.

Die Metallfolie besteht im Allgemeinen aus Kupfer.

Die vorausgehend erwähnten Abmessungen der Metallfolie und der Rillenstruktur sind typische Werte, und die Erfindung ist nicht auf diese Werte beschränkt.

Vorzugsweise werden in die Metallfolie zusätzlich zur Rillenstruktur in Abständen von 1 bis 5 mm in Richtung der Rillenstruktur verlaufende Kerben eingebracht, entlang denen die Metallfolie in die PV-Zellen-Verbinder auftrennbar ist.

Zweckmäßig wird die Tiefe der Kerben so gewählt, dass unabhängig von der Stärke der Metallfolie in den Kerben immer dieselbe restliche Materialstärke verbleibt, vorzugsweise von weniger als 40 µm, und insbesondere eine solche im Bereich von 10 bis 20 µm. Dadurch lässt sich die weitere Verarbeitung der Metallfolie vereinheitlichen. Die Herstellung der Verbinder erfolgt dann vorzugsweise insgesamt in vier Schritten:
Im ersten Schritt wird die Metallfolie oder das Kupferband vorzugsweise einer Stärke von 0,1 bis 0,25 mm und einer Breite von 30 bis 90 mm durch einen ersten Walzenspalt geführt, dessen beide Walzen in einem Abstand von 1 bis 5 mm umlaufende vorstehende keilförmige Rippen aufweisen, die in die Metallfolie entsprechende keilförmige Kerben einer solchen Tiefe einprägen, dass die Materialstärke der Metallfolie in diesen Kerben auf weniger als 40µm und vorzugsweise zwischen 10 und 20 µm reduziert ist und so Schwächungslinien entstehen. An den Rändern der Kerben wird das Material der Metallfolie etwas herausgedrückt, und es bilden sich Wulste. Die Metallfolie wird daher in einem zweiten Walzenspalt mit glatten Walzen wieder geglättet. Die keilförmigen Kerben werden dabei wieder weitgehend geschlossen, die Schwächungslinien bleiben jedoch bestehen und bilden Sollbruchstellen. Entlang dieser Schwächungslinien wird die Metallfolie später in einzelne Bänder aufgetrennt, von denen die PV-Zellen-Verbinder abgetrennt werden.

Die entlang dieser Sollbruchstellen geschwächte Metallfolie wird im zweiten Schritt durch einen dritten Walzenspalt geführt, bei dem es sich um den Walzenspalt des oben bereits erwähnten Walzenaggregats handelt, bei dem zumindest eine Walze eine Oberfläche mit der Rillenstruktur hat, so dass in die Metallfolie eine Rillenstruktur geprägt wird. Die Rillenstruktur hat einen Scheitelabstand von 150-250 µm und eine Tiefe von etwa 30 bis 50 µm. Wenn möglich, wird die Metallfolie so in den dritten Walzenspalt eingeführt, dass die Schwächungslinien mit einem Scheitel der Rillenstruktur der Walzen und dementsprechend mit einem Tal der Rillenstruktur der Metallfolie zusammenfallen. Dies gelingt jedoch nicht immer und ist auch nicht notwendig.

Im dritten Herstellungsschritt werden diejenigen Flächenabschnitte der gerillten Metallfolie, wie oben erläutert, vorverzinnt, die später die Abschnitte des Verbinders bilden, die mit den PV-Zellen verlötet werden.

Im vierten Herstellungsschritt wird die gerillte, in Querstreifen vorverzinnte Metallfolie entlang der Schwächungslinien in schmale Folienbänder aufgetrennt. Dazu wird die Metallfolie durch einen vierten Walzenspalt geführt. Nach dem vierten Walzenspalt ist eine Trenneinrichtung angeordnet, z.B. eine feststehende Trennwalze oder ein Trennkeil, und benachbarte Folienbänder werden abwechselnd über und unter der Trenneinrichtung geführt und dadurch entlang der Schwächungslinien gebrochen und voneinander getrennt. Das Auftrennen der Metallfolie erfolgt zweckmäßig im verfestigten Zustand, wobei die Kaltverfestigung durch das vorausgehende Walzen in dem ersten und zweiten Herstellungsschritt erfolgt. Jedes so gewonnene Folienband wird dann zu einer schmalen Rolle oder einer travers gewickelten Rolle aufgewickelt. Das fertige getrennte und aufgewickelte Band wird dann noch weich geglüht.

In einem automatischen Verarbeitungsverfahren können von diesen Folienbändern dann in bekannter Weise einzelne Verbinder abgeschnitten werden, und die Verbinder mit der Vorderseite einer PV-Zelle und der Rückseite der darauf folgenden PV-Zelle verlötet werden.

Der erste und zweite Herstellungsschritt der Verbinder können auch zusammengefasst werden, indem die Metallfolie durch einen ersten Walzenspalt geführt wird, dessen beide Walzen in einem Abstand von 2 bis 5 mm umlaufende vorstehende keilförmige Rippen und dazwischen eine Oberfläche mit einer Rillenstruktur mit einem Scheitelabstand von 150-250 µm und einer Tiefe von etwa 30 bis 50 µm aufweisen. Auf das Glattdrücken der Randwülste der keilförmigen Kerben muss dann jedoch verzichtet werden, da dadurch auch die Rillenstruktur zwischen den Kerben glatt gedrückt würde.

Dieses in vier Schritten ablaufende Verfahren ist auch bei einer achsparallelen Rillenstruktur der Walze oder Walzen des dritten Walzenspalts einsetzbar, wobei dann auch die Rippen der Walze oder der Walzen des ersten Walzenspaltes achsparallel verlaufen.

Diese vier Herstellungsschritte können in einem getakteten oder kontinuierlichen Prozess durchgeführt werden. Bei einem getakteten Prozess wird die Metallfolie nach dem Prägen (erster und zweiter Herstellungsschritt) aufgespult und dann für das Aufschmelzen der Lotformteile (dritter Herstellungsschritt) wieder abgespult. Das Aufschmelzen der Lotformteile erfolgt dabei mittels des oben erwähnten zweiten Heißprägekopfes, der stationär ist. Danach wird die vorverzinnte Metallfolie wieder aufgespult. Dies ist insbesondere deshalb zweckmäßig, da die Metallfolie in den ersten beiden und im vierten Herstellungsschritt mit gleichförmiger Geschwindigkeit transportiert wird, während sie im dritten Herstellungsschritt (Vorverzinnen) schrittweise entsprechend der Länge der Lotformteile vorwärts bewegt wird.

Bei einem kontinuierlichen Prozess wird die Metallfolie auch im dritten Herstellungsschritt in einem ununterbrochenen Betrieb selektiv mit den Lotformteilen belegt. Die Mechanik zum Auflegen der Lotformteile läuft dabei mit der Metallfolie mit, und zum Aufschmelzen kommt statt des Heißprägekopfes eine Silikon-beschichtete Walze zum Einsatz. Auch hier kann die Metallfolie zwischenaufgewickelt werden, wenn die Herstellungsschritte mit unterschiedlichen Geschwindigkeiten der Metallfolie ablaufen.

Die Breite der eingesetzten Folie und des schließlich hergestellten Bandes kann auch ein Vielfaches der Breite bzw. Länge der PV-Verbinder sein. Die Bänder werden dann zunächst in dieser breiteren Form aufgewickelt und dann erst vor dem Verlöten mit den PV-Zellen in Längs- oder Querrichtung auf das Endmaß geschnitten.

Ein Ausführungsbeispiel der Erfindung wird nachfolgend anhand der Zeichnungen näher erläutert. Es zeigen:
- Fig. 1: einen Verbinder für PV-Zellen im Querschnitt;
- Fig. 2: den Verbinder von Fig. 1 im Längsschnitt;
- Fig. 3: den Verbinder für PV-Zellen in einer räumlichen isometrischen Darstellung;
- Fig. 4: in einer auseinander gezogenen Darstellung drei PV-Zellen mit den dazugehörigen Verbindern;
- Fig. 5: die drei PV-Zellen von Fig. 4 in verbundenem Zustand;
- Fig. 6: schematisch das Herstellungsverfahren der Verbinder für PV-Zellen;
- Fig. 7: im Schnitt den ersten Walzenspalt;
- Fig. 8: im Schnitt den zweiten Walzenspalt; und
- Fig. 9: im Schnitt den dritten Walzenspalt.

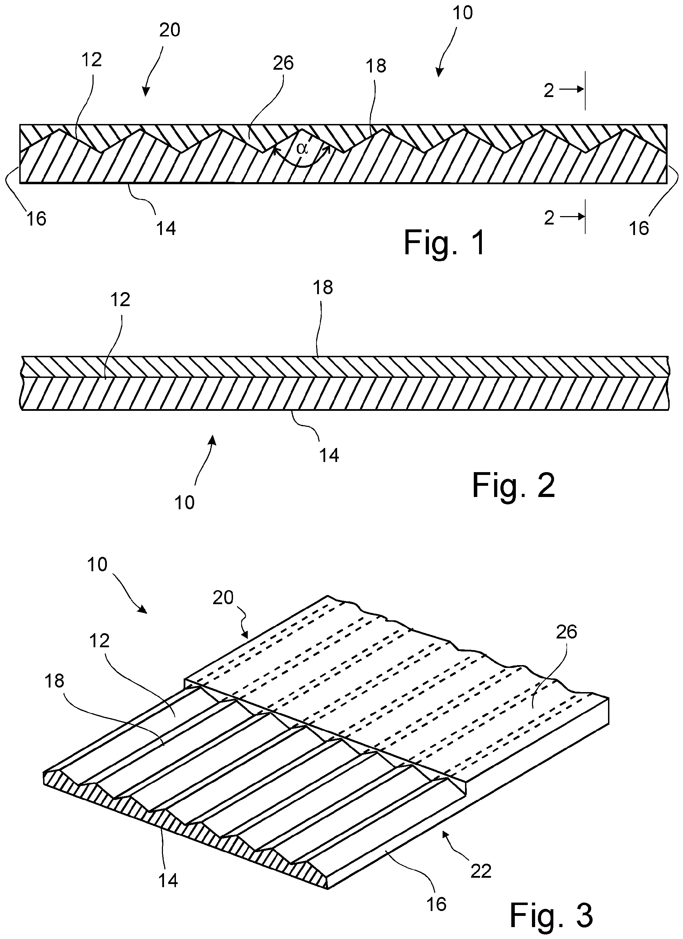

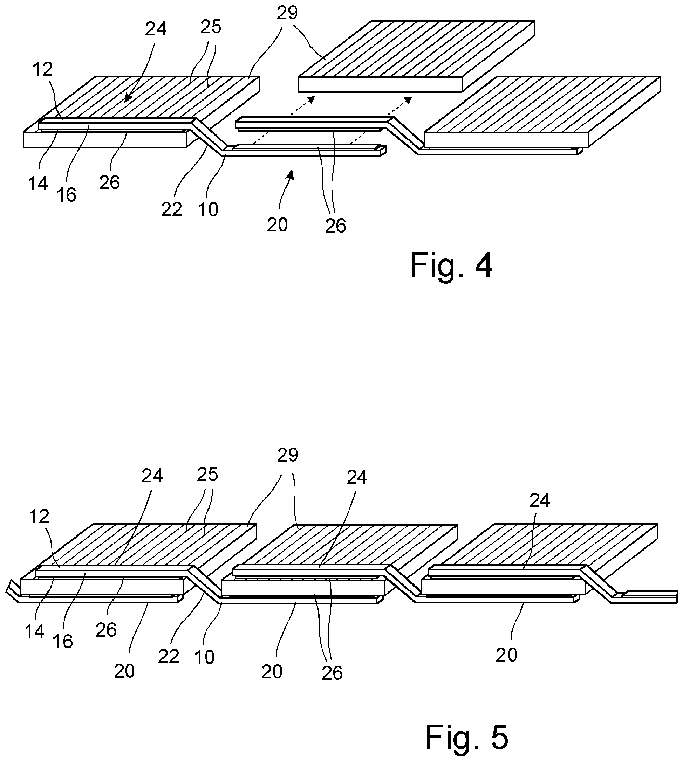

Mittels des erfindungsgemäßen Verfahrens soll ein vorverzinnter Verbinder für PV-Zellen 29 (Fig. 4 und 5) hergestellt werden, der ein Streifen 10 mit einem flachen Querschnitt und einer ersten, oberen Breitseite 12 und einer zweiten, unteren Breitseite 14 sowie zwei Schmalseiten 16 ist, die jeweils die gegenüberliegenden Ränder der Breitseiten 12, 14 verbinden. Der Querschnitt des Streifens 10 hat eine Breite von 1 mm und eine Höhe von 0,1 mm (Fig. 1). Der Streifen 10 hat einen Kupferkern und trägt auf seiner oberen und unteren Breitseite eine dünne Silberschicht zur Verbesserung der elektrischen Leitfähigkeit und des Reflexionsvermögens. Die Silberschicht ist in den Zeichnungen nicht dargestellt.

Während die untere Breitseite 14 glatt ist, hat die obere Breitseite 12 eine Rillenstruktur 18 mit einem Dreieck-Profil (Fig. 1) mit einem Winkel α von 120° am Scheitel und im Tal. Der Scheitelabstand der Rillenstruktur 18 beträgt 150 µm und die Tiefe der Rillenstruktur dementsprechend etwa 40 µm. Der Streifen hat eine Länge von 305,5 mm und ist in drei Bereiche unterteilt. In einem ersten Bereich 20 von 145 mm Länge ist der Streifen auf der die Rillenstruktur 18 tragenden oberen Breitseite 12 vorverzinnt, und zwar ist die Rillenstruktur 18 mit dem Lötzinn 26 derart ausgefüllt, dass der Streifen 10 von Außen betrachtet in dem ersten Bereich 20 nahezu glatt ist. Das Lötzinn 26 überdeckt die Scheitel der Rillenstruktur 18 dabei sogar um einige Mikrometer. An den ersten Bereich 20 schließt sich ein Zwischenbereich 22 an, in dem der Streifen 10 weder auf der oberen Breitseite 12 noch auf der unteren Breitseite 14 verzinnt ist. Der Zwischenbereich 22, der als Verbindungsbereich fungiert, hat eine Länge von 15 mm. An ihn schließt sich ein zweiter Bereich 24 an, der wiederum eine Länge von 145 mm hat und bei dem die untere Breitseite 14 vorverzinnt ist. Die Stärke der Vorverzinnung beträgt etwa 10 µm.

Einschließlich eines Schnittspiels von 0,5 mm hat der Streifen 10 damit eine Länge von 305,5 mm. Die Länge des ersten und zweiten Bereichs 20, 24 ist etwas kleiner als die Kantenlänge einer Sechs-Zoll-Zelle (Fig. 4 und 5). Der Verbindungsbereich 22 entspricht dem Abstand zweier PV-Zellen 29 innerhalb eines Moduls. Die untere Breitseite 14 des zweiten Bereichs 24 wird jeweils mit der Oberseite einer PV-Zelle 29 verlötet, so dass eine Verbindung mit den einzelnen Kontaktfingern 25 der PV-Zelle 29 besteht. Da die PV-Zellen 29 in Serie geschaltet sind, wird der erste Bereich 20, in dem die Rillenstrukturen 18 mit Lötzinn 26 vollständig gefüllt ist, mit der Unterseite der benachbarten PV-Zelle 29 verlötet, so dass dort ebenfalls Kontakt mit den Kontaktfingern besteht. Auf der Oberseite dieser PV-Zelle 29 ist dann der zweite Bereich 24 des nächsten Verbinders aufgelötet, dessen erster Bereich 20 wiederum mit der Unterseite der übernächsten PV-Zelle 29 verlötet ist. Auf diese Weise ist eine Mehrzahl von PV-Zellen in Serie geschaltet.

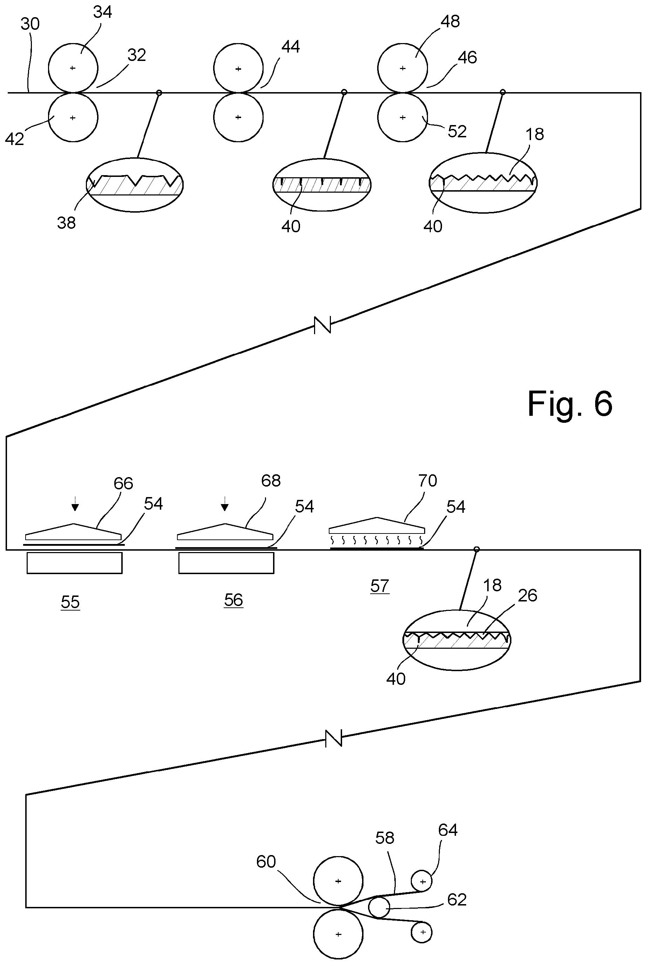

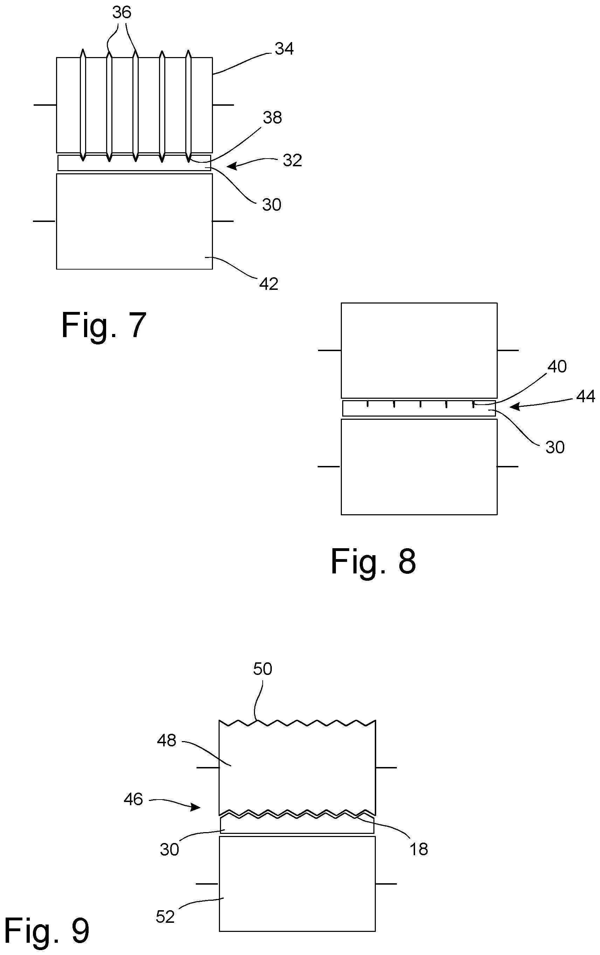

Die Herstellung von vorverzinnten Verbindern für PV-Zellen mit einseitiger Rillenstruktur erfolgt in vier Schritten (Fig. 6), wobei hier ein getakter Prozess beschrieben wird:
In einem ersten Schritt wird eine Kupferfolie oder -band 30 einer Stärke von 0,1 mm und einer Breite von 30 mm durch einen ersten Walzenspalt 32 geführt, dessen obere Walze 34 in einem Abstand von 1 mm umlaufende vorstehende keilförmige Rippen 36 aufweist, die in die Kupferfolie 30 entsprechende keilförmige Kerben 38 einer Tiefe von 80 µm einprägen (Fig. 7), so dass Schwächungslinien 40 entstehen (Fig. 6 und 8). Die untere Walze 42 ist glatt. An den Rändern der Kerben 38 wird das Material der Kupferfolie 30 etwas herausgedrückt und bilden sich Wulste. Die Kupferfolie 30 wird daher in einem zweiten Walzenspalt 44 mit glatten Walzen geglättet. Die keilförmigen Kerben 38 werden dabei wieder weitgehend geschlossen, die Schwächungslinien 40 bleiben jedoch bestehen und bilden Sollbruchstellen (Fig. 8).

In einem zweiten Schritt wird die Kupferfolie 30 durch einen dritten Walzenspalt 46 geführt, dessen obere Walze 48 eine Oberfläche mit einer Rillenstruktur 50 mit einem Scheitelabstand von 150 µm und einer Tiefe von etwa 40 µm haben (Fig. 9). Die Rillenstruktur 50 weist jeweils längs verlaufende Kämme oder Scheitel und Täler auf. Der Winkel α an den Kämmen und in den Tälern der Rillenstruktur 50 beträgt 120°. Die untere Walze 52 des dritten Walzenspalts 46 ist glatt. In dem dritten Walzenspalt 46 prägt die Rillenstruktur 50 der oberen Walze 48 die entsprechende Rillenstruktur 18 in die Kupferfolie 30. Die Kupferfolie 30 wird so in den dritten Walzenspalt 46 eingeführt, dass die Schwächungslinien 40 mit einem Scheitel der Rillenstruktur 50 der oberen Walze 48 und dementsprechend mit einem Tal der in die Kupferfolie 30 eingeprägten Rillenstruktur 18 zusammenfallen.

In einem dritten Herstellungsschritt werden dann diejenigen Flächenabschnitte der Kupferfolie 30 vorverzinnt, die später die ersten Bereiche 20 der oberen Breitseite 12 und die zweiten Bereiche 24 der unteren Breitseite 14 des Verbinders werden, die mit den PV-Zellen 29 verlötet werden. Dazu wird Lötzinn in Form von Lotformteilen 54 auf die Kupferfolie 30 aufgelegt (Fig. 6). Das für die Verzinnung erforderliche Lötflussmittel ist zuvor auf die Lotformteile 54 aufgetragen worden. Mittels eines dreistufigen Verfahrens werden die Lotformteile 54 mit der Kupferfolie 30 verbunden. In der ersten Stufe werden die Lotformteile 54 durch punktweises Heißprägen mittels eines ersten Heißprägekopfes 66 angeheftet, der zwei Prägestempel aufweist. Mittels eines Sauggreifers wird dabei ein vorgeschnittenes Lotformteil 54 auf der momentan angehaltenen Kupferfolie 30 in Position gebracht und gehalten. Der Sauggreifer weist zwei beabstandete Aussparungen auf, durch die die zwei Stempel des ersten Heißprägekopfes hindurch fahren, und an diesen Stellen das Lotformteil 54 durch Hitze und Druck auf der Kupferfolie 30 anheften. Die Kupferfolie 30 mit dem angehefteten Lotformteil 54 wird dann weitergetaktet, und in der zweiten Stufe werden die Lotformteile 54 wiederum durch Heißprägen mittels eines zweiten Heißprägekopfes 68 vollflächig verpresst. Die Kupferfolie 30 mit dem verpressten Lotformteil 54 wird dann wieder weitergetaktet, und in der dritten Stufe werden die angehefteten und vollflächig verpressten Lotformteile 54 mittels eines Infrarotstrahlers 70 aufgeschmolzen.

Die Lotformteile 54 sind Lotzinnstreifen, deren Breite etwas weniger als die Kantenlänge von 156 mm einer Sechs-Zoll-PV-Zelle ist und 145 mm, beträgt. Die Lotzinnstreifen 54 werden quer zur Rillenstruktur 18 der Kupferfolie 30 aufgelegt.

In einem vierten Herstellungsschritt wird die gerillte, in Querstreifen vorverzinnte Kupferfolie 30 entlang der Schwächungslinien 40 in schmale Folienbänder 58 aufgetrennt. Dazu wird die Kupferfolie 30 durch einen vierten Walzenspalt 60 mit glatten Walzen geführt, die keinen oder nur einen minimalen Druck auf die Folie 30 ausüben. Nach dem Walzenspalt ist eine feststehende Trennwalze 62 als Trenneinrichtung angeordnet, und benachbarte Folienbänder 58 werden abwechselnd über und unter der Trennwalze 62 geführt und dadurch aufgrund der Schwächungslinien 40 voneinander getrennt. Jedes so gewonnene Folienband 58 wird dann zu einer travers gewickelten Rolle 64 aufgewickelt.

Wenn die Kupferfolie 30 keine Schwächungslinien 40 aufweisen soll, so entfallen der erste und zweite Walzenspalt 32, 44. Die mit der Rillenstruktur 18 versehene und vorverzinnte Kupferfolie 30 wird dann mittels Rollenscheren in die Folienbänder 58 unterteilt.

Da die ersten beiden und der vierte Herstellungsschritt kontinuierlich ablaufen, während die Metallfolie 30 im dritten Herstellungsschritt, dem Vorverzinnen, schrittweise weiterbewegt wird, wird die Metallfolie 30 nach den ersten beiden Herstellungsschritten aufgespult und dann für den dritten Herstellungsschritt wieder abgespult. Ebenso wird sie nach dem dritten Herstellungsschritt aufgespult und dann für den vierten Herstellungsschritt wieder abgespult. In Fig. 6 ist das zwischenzeitliche Aufspulen durch Unterbrechungen der die Kupferfolie 30 darstellenden Linie angezeigt. Auch nach dem Durchgang durch den ersten und zweiten Walzenspalt 32, 44 kann die Kupferfolie 30 zwischenzeitlich aufgespult werden.

Üblicherweise haben die Streifen 10 der PV-Zellen-Verbinder auf der unteren und der oberen Breitseite eine Rillenstruktur 18. Zur Herstellung solcher PV-Zellen-Verbinder hat dann auch die untere Walze 42 des ersten Walzenspalts 32 eine Rillenstruktur 50. Üblicherweise werden dann auch Bereiche beider Seiten der Metallfolie 30 verzinnt. Die verzinnten Bereiche der Oberseite und der Unterseite der Metallfolie 30 überlappen sich dabei nicht, sondern haben in Längsrichtung einen Abstand, der abwechselnd etwa dem Abstand zweier miteinander zu verbindenden PV-Zellen 29 und einem Schnittspiel von 0,5 mm entspricht.

Beide Seiten der Metallfolie 30 können auch vollständig verzinnt werden. Daraus geschnittene PV-Zellen-Verbinder können dann für jede Größe von PV-Zellen verwendet werden. Allerdings gehen dann die vorteilhaften Reflexionseigenschaften verloren. Zweckmäßig sollte daher mindestens eine Seite der Metallfolie 30 nur in den Bereichen verzinnt werden, die nach dem Unterteilen in PV-Zellen-Verbinder die ersten Bereiche 20 der oberen Breitseite 12 der PV-Zellen-Verbinder bilden, mit denen dieser auf der Unterseite einer PV-Zelle 29 angelötet wird.

**Liste der Bezugszeichen**

| | |
|---|---|
| 10 Streifen | 42 untere Walze |
| 12 obere Breitseite | 44 zweiter Walzenspalt |
| 14 untere Breitseite | 46 dritter Walzenspalt |
| 16 Schmalseite | 48 obere Walze |
| 18 Rillenstruktur Streifen/Folie | 50 Rillenstruktur der Walze |
| 20 erster Bereich | 52 untere Walze |
| 22 Zwischenbereich | 54 Lotformteile |
| 24 zweiter Bereich | 55 erste Stufe (punktw. Heißprägen) |
| 25 Kontaktfinger | 56 zweite Stufe (vollfl. Heißprägen) |
| 26 Lötzinn | 57 dritte Stufe (Aufschmelzen) |
| 29 PV-Zelle | 58 Folienbänder |
| 30 Kupferfolie | 60 vierter Walzenspalt |
| 32 erster Walzenspalt | 62 Trennwalze |
| 34 obere Walze | 64 Rolle |
| 36 Rippen | 66 erster Heißprägekopf |
| 38 Kerben | 68 zweiter Heißprägekopf |
| 40 Schwächungslinie | 70 Infrarotstrahler |

## Patentansprüche

1. Verfahren zum Herstellen von vorverzinnten Streifen (10) von Verbindern für Photovoltaik-Zellen, wobei
- eine Metallfolie (30) durch einen Walzenspalt (46) eines Walzenaggregats geführt wird, bei dem zumindest eine Walze (48) eine Oberfläche mit einer Rillenstruktur (50) hat, so dass zumindest in eine Seite der Metallfolie (30) eine Rillenstruktur (18) geprägt wird, die Kämme oder Scheitel und Täler aufweist,
- Lötzinn in Form von Lotformteilen (54) auf die die eingeprägte Rillenstruktur (18) aufweisende Seite der Metallfolie (30) aufgelegt wird, wobei das für die Verzinnung erforderliche Lötflussmittel zuvor auf die Lotformteile (54) oder die Metallfolie (30) aufgetragen worden ist,
- die Lotformteile (54) auf die Metallfolie (30) aufgeschmolzen werden und
- die die eingeprägte Rillenstruktur (18) aufweisende und verzinnte Metallfolie (30) in parallele Bänder (58) getrennt wird,
wobei die Lotformteile (54) eine solche Stärke haben, dass nach dem Aufschmelzen der Lotformteile (54) die Rillenstruktur (18) mindestens aufgefüllt ist.

2. Verfahren nach Anspruch 1, wobei das Aufschmelzen dadurch erfolgt, dass
- die Lotformteile (54) punktuell auf die Metallfolie (30) angeheftet werden,
- die angehefteten Lotformteile (58) dann vollflächig mit der Metallfolie (30) verpresst werden, und
- schließlich die angehefteten und vollflächig verpressten Lotformteile (54) aufgeschmolzen werden.

3. Verfahren nach Anspruch 1, wobei das Aufschmelzen dadurch erfolgt, dass
- die Lotformteile (54) auf die Metallfolie (30) angedrückt werden, die zuvor mit Lötflussmittel versehen wurde, und
- die angedrückten Lotformteile (54) vollflächig mit der Metallfolie (30) verpresst und aufgeschmolzen werden.

4. Verfahren nach Anspruch 1, 2 oder 3, wobei beide Walzen (48, 52) eine Oberfläche mit einer Rillenstruktur (50) haben, so dass in beide Seiten der Metallfolie (30) eine Rillenstruktur (18) geprägt wird, wobei beide Seiten der Metallfolie (30) in Bereichen (20, 24) verzinnt werden, deren Länge etwas kleiner ist als die Kantenlänge einer Photovoltaik-Zelle (29), und wobei die Bereiche (20) auf der einen Seite der Metallfolie (30) von den Bereichen (24) auf der anderen Seite der Metallfolie (30) in Längsrichtung einen Abstand aufweisen, der abwechselnd etwa dem Abstand zweier miteinander zu verbindenden Photovoltaik-Zellen (29) und einem Schnittspiel entspricht.

5. Verfahren nach einem der Ansprüche 1 bis 4, wobei das Lötzinn (26) nach dem Aufschmelzen geringfügig über die Scheitel der Rillenstruktur (18) vorsteht.

6. Verfahren nach einem der Ansprüche 1 bis 5, wobei die Metallfolie (30) eine Stärke von 0,1 bis 0,25 mm und einer Breite von 30 bis 90 mm hat und die Walzen (48, 52) eine umlaufende Rillenstruktur (18) aufweisen.

7. Verfahren nach einem der Ansprüche 1 bis 3, wobei nur eine der Walzen (48) des Walzenaggregats eine Oberfläche mit der Rillenstruktur (50) aufweist, so dass nur in eine Seite der Metallfolie (30) eine Rillenstruktur (18) geprägt wird.

8. Verfahren nach einem der Ansprüche 1 bis 7 oder nach Anspruch 7 in Kombination mit Anspruch 5, wobei die Metallfolie (30) durch einen ersten Walzenspalt (32) geführt wird, bei dem zumindest eine Walze (34) in einem Abstand von 1 bis 5 mm umlaufende vorstehende keilförmige Rippen (36) aufweist, die in die Metallfolie (30) entsprechende keilförmige Kerben (38) einer solchen Tiefe einprägen, dass die Materialstärke der Metallfolie (30) in diesen Kerben (38) auf weniger als 40 µm reduziert ist und so Schwächungslinien (40) entstehen.

9. Verfahren nach Anspruch 8, wobei die Metallfolie (30) durch einen zweiten Walzenspalt (44) mit glatten Walzen geführt wird, wodurch an den Rändern der Kerben (38) herausgedrückte Wülste wieder geglättet werden.

## Claims

1. Method for producing pretinned strips (10) of connectors for photovoltaic cells, wherein:
- a metal foil (30) is guided through a roll gap (46) of a rolling mill in which at least one work roll (48) has a surface with a corrugated structure (50) with the result that a corrugated structure (18) which has crests or peaks and troughs is embossed into at least one side of the metal foil (30),
- soldering tin in the form of solder preforms (54) is applied to the side of the metal foil (30) with the embossed corrugated structure (18), wherein the soldering flux necessary for the tinning has been applied in advance to the solder preforms (54) or the metal foil (30),
- the solder preforms (54) are melted onto the metal foil (30) and
- the pretinned metal foil (30) which has the embossed corrugated structure (18) is separated into parallel ribbons (58),
wherein the solder preforms (54) have a thickness such that the corrugated structure (18) is at least full after melting on the solder preforms (54).

2. Method according to claim 1, wherein the melting on takes place by
- temporarily attaching, pointwise, the solder preforms (54) to the metal foil (30),
- then pressing the temporarily attached solder preforms (58) over the whole surface with the metal foil (30), and
- finally melting on the temporarily attached solder preforms pressed over their whole surface (54).

3. Method according to claim 1, wherein the melting on takes place by
- pressing the solder preforms (54) onto the metal foil (30) to which soldering flux has been applied in advance, and
- melting on the temporarily attached solder preforms (54) pressed over their whole surface.

4. Method according to claim 1, 2 or 3, wherein both work rolls (48, 52) have a surface with a corrugated structure (50), with the result that a corrugated structure (18) is embossed into both sides of the metal foil (30), wherein both sides of the metal foil (30) are pretinned in areas (20, 24), the length of which is somewhat less than the length of the edge of a photovoltaic cell (29), and wherein the areas (20) on one side of the metal foil (30) are separated from the areas (24) on the other side of the metal foil (30) in longitudinal direction by a gap which alternately roughly corresponds to the distance between two photovoltaic cells (29) to be connected to one another and a cutting tolerance.

5. Method according to one of claims 1 to 4, wherein the soldering tin (26) stands slightly higher than the peaks of the corrugated structure (18) after melting on.

6. Method according to one of claims 1 to 5, wherein the metal foil (30) is 0.1 to 0.25 mm thick and 30 to 90 mm wide and the work rolls (48, 52) have a circular corrugated structure (18).

7. Method according to one of claims 1 to 3, wherein only one of the work rolls (48) of the rolling mill has a surface area with the corrugated structure (50), with the result that a corrugated structure (18) is embossed into only one side of the metal foil (30).

8. Method according to one of claims 1 to 7 or in accordance with claim 7 combined with claim 5, wherein the metal foil (30) is guided through a first roll gap (32), in which at least one work roll (34) has circular protruding wedge-shaped ribs (36) at a distance of 1 to 5 mm which emboss corresponding wedge-shaped notches (38) into the metal foil (30) to such a depth that the material thickness of the metal foil (30) in these notches (38) is reduced to less than 40 µm and thus lines of weakness (40) form.

9. Method according to claim 8, wherein the metal foil (30) is guided through a second roll gap (44) with smooth work rolls, whereby ridges pushed out at the edges of the notches (38) are smoothed again.

## Revendications

1. Procédé pour fabriquer des bandes pré-étamées (10) de connecteurs pour des cellules photovoltaïques, dans lequel
- une feuille métallique (30) est guidée à travers un espace entre cylindres (46) d'une unité de laminage, dans laquelle au moins un cylindre (48) présente une surface pourvue d'une structure rainurée (50), de sorte qu'une structure rainurée (18), qui comporte des crêtes ou des pics et des creux, est estampée dans au moins un côté de la feuille métallique (30),
- de l'étain à braser sous la forme de préformés de brasage (54) est posé sur le côté de la feuille métallique (30) présentant la structure rainurée (18) estampée, le flux décapant nécessaire pour l'étamage ayant été appliqué auparavant sur les préformés de brasage (54) ou la feuille métallique (30),
- les préformés de brasage (54) sont fondus sur la feuille métallique (30) et
- la feuille métallique (30) étamée et présentant la structure rainurée (18) estampée est séparée en bandes parallèles (58),
les préformés de brasage (54) ayant une épaisseur telle qu'après la fusion des préformés de brasage (54), la structure rainurée (18) est au moins remplie.

2. Procédé selon la revendication 1, dans lequel la fusion est effectuée par
- fixation ponctuelle des préformés de brasage (54) sur la feuille métallique (30),
- puis compression des préformés de brasage (58) fixés sur toute la surface avec la feuille métallique (30), et
- enfin fusion des préformés de brasage (54) fixés et comprimés sur toute la surface.

3. Procédé selon la revendication 1, dans lequel la fusion est effectuée par
- pression des préformés de brasage (54) sur la feuille métallique (30), qui a auparavant été pourvue de flux décapant, et
- compression des préformés de brasage (54) pressés avec la feuille métallique (30) sur toute la surface et fusion de ceux-ci.

4. Procédé selon la revendication 1, 2 ou 3, dans lequel les deux cylindres (48, 52) présentent une surface pourvue d'une structure rainurée (50), de sorte qu'une structure rainurée (18) est estampée dans les deux côtés de la feuille métallique (30), les deux côtés de la feuille métallique (30) étant étamés dans des zones (20, 24), dont la longueur est légèrement inférieure à la longueur d'arête d'une cellule photovoltaïque (29), et les zones (20) sur un côté de la feuille métallique (30) présentant un écart dans le sens de la longueur par rapport aux zones (24) sur l'autre côté de la feuille métallique (30), ledit écart correspondant alternativement approximativement à l'écart entre deux cellules photovoltaïques (29) à connecter l'une à l'autre et à un jeu de coupe.

5. Procédé selon l'une des revendications 1 à 4, dans lequel, après la fusion, l'étain à braser (26) dépasse légèrement au-dessus des pics de la structure rainurée (18).

6. Procédé selon l'une des revendications 1 à 5, dans lequel la feuille métallique (30) présente une épaisseur de 0,1 à 0,25 mm et une largeur de 30 à 90 mm et les cylindres (48, 52) présentent une structure rainurée (18) périphérique.

7. Procédé selon l'une des revendications 1 à 3, dans lequel seulement un des cylindres (48) de l'unité de laminage présente une surface pourvue de la structure rainurée (50), de sorte qu'une structure rainurée (18) est estampée uniquement dans un côté de la feuille métallique (30).

8. Procédé selon l'une des revendications 1 à 7 ou selon la revendication 7 en combinaison avec la revendication 5, dans lequel la feuille métallique (30) est guidée à travers un premier espace entre cylindres (32), dans lequel au moins un cylindre (34) présente des rainures (36) cunéiformes périphériques en saillie espacées de 1 à 5 mm, qui estampent dans la feuille métallique (30) des encoches (38) cunéiformes correspondantes d'une profondeur telle que l'épaisseur de matériau de la feuille métallique (30) est réduite dans ces encoches (38) à moins de 40 µm et que des lignes de moindre résistance (40) sont ainsi créées.

9. Procédé selon la revendication 8, dans lequel la feuille métallique (30) est guidée à travers un second espace entre cylindres (44) avec des cylindres lisses, moyennant quoi des renflements formés aux bords des encoches (38) sont de nouveau lissés.
